(19) Europäisches Patentamt
European Patent Office
Office européen des brevets

(11) **EP 2 109 112 A1**

(12) **DEMANDE DE BREVET EUROPEEN**

(43) Date de publication:
**14.10.2009 Bulletin 2009/42**

(51) Int Cl.:
***G11C 17/16*** *(2006.01)*  ***G11C 17/18*** *(2006.01)*

(21) Numéro de dépôt: **09157269.3**

(22) Date de dépôt: **03.04.2009**

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **08.04.2008 FR 0852354**

(71) Demandeur: **STMicroelectronics SA**
**92120 Montrouge (FR)**

(72) Inventeur: **Damiens, Joël**
**73290, LA MOTTE SERVOLEX (FR)**

(74) Mandataire: **Zapalowicz, Francis**
**Bureau D.A. Casalonga-Josse**
**Bayerstrasse 71/73**
**80335 München (DE)**

(54) **Procédé de programmation d'un dispositif de mémoire du type programmable une fois et circuit intégré incorporant un tel dispositif de mémoire.**

(57) Le circuit intégré comprend un dispositif de mémoire du type électriquement programmable de façon irréversible comportant au moins une cellule-mémoire (CEL) comportant une zone diélectrique (C) disposée entre une première électrode (EC1) électriquement couplée à une première borne (BA) d'alimentation et une deuxième électrode (EC2) électriquement couplée à un circuit d'accès incluant au moins un transistor d'accès (TR). Le dispositif de mémoire (DM) comprend en outre un circuit auxiliaire (CAX) comportant un transistor auxiliaire (TRX) électriquement couplé entre ladite première électrode et ladite première borne d'alimentation, apte à être commandé sur son électrode de commande auxiliaire de façon à être passant lorsque le circuit d'accès (TR) est passant, et agencé de façon à présenter un courant de saturation inférieur au courant de saturation du circuit d'accès.

FIG.1

**Description**

L'invention concerne les circuits intégrés, et notamment les dispositifs intégrés de mémoires du type « programmable une fois », également connues par l'homme du métier sous la dénomination anglosaxonne de mémoire « OTP » (« One Time Programmable » Memory ).

Ce type de mémoire est bien connu de l'homme du métier. Elle comporte des éléments fusibles, tels que des condensateurs, que l'on vient « claquer » électriquement, c'est-à-dire qu'on détériore électriquement de façon irréversible le diélectrique du condensateur, de sorte que celui-ci se comporte alors comme une résistance de faible valeur.

La fiabilité des cellules-mémoires en mode de programmation est un élément important. Cette fiabilité est affectée, en ce qui concerne les cellules non sélectionnées lors de la programmation, par les contraintes sur l'oxyde de grille du transistor d'accès de la cellule-mémoire. Ces contraintes peuvent être tolérées sur des transistors MOS d'accès du type « à gradient de champ » (« Drift Transistor », selon une dénomination anglosaxonne bien connue de l'homme du métier).

Ces contraintes peuvent être également limitées en utilisant des dispositifs d'accès formant des montages cascodes ou encore en utilisant des commutateurs haute tension disposés en parallèle sur les lignes de mots de la mémoire.

En ce qui concerne les cellules sélectionnées lors de la programmation, leur fiabilité est affectée par le phénomène de dégradation de porteurs chauds.

Ce problème de fiabilité se pose notamment pour des technologies CMOS 65 nanomètres et moins, en raison notamment du fort courant traversant le transistor d'accès présentant une forte tension drain/source. Une solution pour réduire ce fort courant consiste à utiliser des transistors d'accès ayant des longueurs de canal importantes, mais ceci a un impact négatif sur la surface de la cellule-mémoire.

Une autre solution consiste à réduire la tension de programmation mais cela a un impact négatif sur la durée de programmation.

Par ailleurs, il est difficile actuellement de détecter l'instant effectif de programmation, c'est-à-dire le moment où la zone diélectrique a été effectivement « claquée ». Aussi, on fixe actuellement une durée de programmation, suffisamment longue, au bout de laquelle on estime que la programmation de la cellule a effectivement eu lieu de façon quasi certaine. Cependant, il s'avère que cette durée n'est pas optimisée car dans la majeure partie des cas, la détérioration du diélectrique a eu lieu bien avant l'expiration de cette durée.

Selon un mode de réalisation et de mise en oeuvre, il est proposé un procédé et un circuit intégré permettant d'améliorer la fiabilité du transistor d'accès d'une cellule-mémoire au cours de la programmation, lorsque cette cellule-mémoire est effectivement sélectionnée.

Selon un autre mode de réalisation et de mise en oeuvre, il est également proposé un procédé et un circuit intégré permettant une détection plus précise de l'instant effectif de programmation d'une celleule-mémoire.

Selon un aspect, il est proposé un circuit intégré comprenant un dispositif de mémoire du type électriquement programmable de façon irréversible comportant au moins une cellule-mémoire comportant une zone diélectrique disposée entre une première électrode électriquement couplée à une première borne d'alimentation, par exemple destinée à recevoir une tension de programmation, et une deuxième électrode électriquement couplée à un circuit d'accès incluant au moins un transistor d'accès.

Selon une caractéristique générale de cet aspect, le dispositif de mémoire comprend en outre un circuit auxiliaire comportant un transistor auxiliaire électriquement couplé entre ladite première électrode et ladite première borne d'alimentation, apte à être commandé sur son électrode de commande auxiliaire de façon à être passant lorsque le circuit d'accès est passant, et agencé de façon à présenter un courant de saturation inférieur au courant de saturation du circuit d'accès.

Ainsi, le courant circulant dans la cellule-mémoire lors de la programmation est égal au courant de saturation du transistor auxiliaire, qui est inférieur au courant de saturation du circuit d'accès. Par ailleurs, la tension drain/source du ou des transistors d'accès de la cellule-mémoire est inférieure à la tension drain/source de saturation qui est elle-même inférieure à la tension drain/source nominale. De ce fait, le ou les transistors d'accès fonctionnent dans une plage nominale et leur fiabilité est ainsi améliorée.

Il convient de noter que pour des facilités de commande de programmation, en particulier sur des plans-mémoires, le transistor auxiliaire peut être rendu passant avant que la cellule soit effectivement sélectionnée, c'est-à-dire avant que le circuit d'accès soit lui-même passant.

Selon un mode de réalisation, le dispositif de mémoire comprend en outre des moyens de détection électriquement couplés au transistor auxiliaire, et aptes à détecter une dégradation de la zone diélectrique de la cellule-mémoire lors d'une programmation irréversible de ladite cellule-mémoire.

Selon un mode de réalisation, le transistor auxiliaire comporte une première électrode auxiliaire électriquement couplée à ladite première borne d'alimentation, et une deuxième électrode auxiliaire électriquement couplée à ladite première électrode, et les moyens de détection sont aptes à détecter une variation de tension en un endroit situé entre ladite deuxième électrode auxiliaire et ladite première électrode.

Selon un mode de réalisation, le dispositif de mémoire comprend en outre un circuit de polarisation, électriquement couplé à ladite électrode de commande auxiliaire, et comportant un premier transistor, identique au transistor d'accès, un deuxième transistor électriquement couplé entre le premier transistor et la première borne d'alimentation, et formant avec ledit transistor auxiliaire un miroir de courant, le rapport W/L de ce deuxième transistor étant supérieur au rapport W/L du transistor auxiliaire, W et L désignant respectivement la largeur et la longueur du canal de transistor.

Un tel mode de réalisation permet aisément d'obtenir un courant de saturation du transistor auxiliaire inférieur au courant de saturation du transistor d'accès.

De façon à améliorer encore la fiabilité, en particulier celle du transistor auxiliaire, ainsi que pour le cas échéant augmenter la précision dans la copie de courants, il est particulièrement avantageux d'utiliser des montages cascodes.

Ainsi, selon un mode de réalisation, le circuit auxiliaire comporte en outre un premier transistor supplémentaire électriquement couplé entre le transistor auxiliaire et ladite première électrode, et formant avec le transistor auxiliaire un premier montage cascode. Le circuit de polarisation comporte en outre un deuxième transistor supplémentaire électriquement couplé entre le premier transistor et le deuxième transistor, et formant avec le premier transistor un deuxième montage cascode.

L'utilisation d'un circuit auxiliaire tel que mentionné ci-avant, est compatible avec toute organisation de plan-mémoire et tout type de programmation du plan-mémoire.

Ainsi, dans un mode de réalisation dans lequel le dispositif de mémoire comporte un plan-mémoire comportant des premiers ensembles de cellules-mémoires, par exemple des lignes de cellules-mémoires, s'étendant selon une première direction et des deuxièmes ensembles de cellules-mémoires, par exemple des colonnes de cellules-mémoires, s'étendant selon une deuxième direction, toutes les premières électrodes des cellules-mémoires étant électriquement couplées à ladite borne d'alimentation, le circuit auxiliaire peut être commun à toutes les colonnes de cellules-mémoires, ce qui permet alors par exemple une programmation bit par bit.

En variante, il peut être prévu un circuit auxiliaire par colonne de cellules-mémoires et un seul circuit de polarisation pour tous les circuits auxiliaires. Ceci permet une programmation par mots de plusieurs bits.

Il est également possible, lorsque les colonnes sont regroupées par groupes, par exemple par paires, de prévoir un circuit auxiliaire par groupe de colonnes, et un seul circuit de polarisation pour tous les circuits auxiliaires.

Selon un autre aspect, il est également proposé un procédé de programmation d'un dispositif de mémoire du type électriquement programmable de façon irréversible comportant au moins une cellule-mémoire comportant une zone diélectrique électriquement couplée à un circuit d'accès incluant au moins un transistor d'accès.

Selon une caractéristique générale de cet autre aspect, on applique une tension de programmation sur ladite zone diélectrique au travers d'un transistor auxiliaire dans son état passant, le courant de saturation du transistor auxiliaire étant inférieur au courant de saturation du circuit d'accès.

Selon un mode de mise en oeuvre, on détecte une dégradation de la zone diélectrique de la cellule-mémoire lors d'une programmation irréversible de ladite cellule-mémoire, par exemple par une détection de la variation de tension en un endroit situé entre le transistor auxiliaire et la zone diélectrique.

D'autres avantages et caractéristiques de l'invention apparaîtront à l'examen de la description détaillée de modes de mise en oeuvre et de réalisation, nullement limitatifs, et des dessins annexés sur lesquels :

- la figure 1 illustre de façon schématique un premier mode de réalisation d'une cellule-mémoire équipée d'un circuit auxiliaire ;
- la figure 2 illustre des variations de tension dans le dispositif de mémoire au cours d'une opération de programmation ;
- la figure 3 illustre de façon schématique un mode de réalisation d'un dispositif de mémoire selon l'invention comportant des moyens de détection de la programmation d'une cellule-mémoire ;
- la figure 4 illustre de façon schématique un autre mode de réalisation d'une cellule-mémoire équipée d'un circuit auxiliaire ;
- la figure 5 illustre encore un autre mode de réalisation d'une cellule-mémoire équipée d'un circuit auxiliaire ; et
- les figures 6 à 8 illustrent de façon schématique différents exemples d'organisation de plans-mémoires équipés d'un ou de plusieurs circuits auxiliaires.

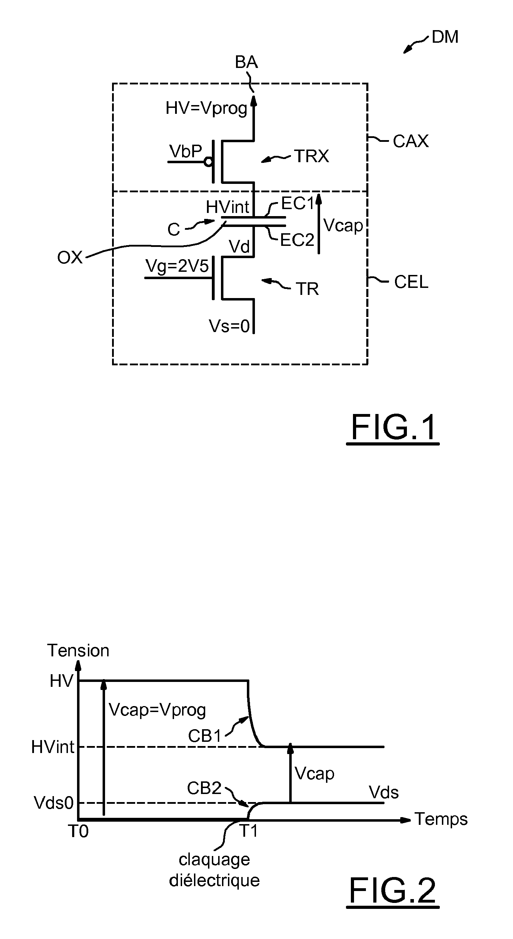

Sur la figure 1, la référence CEL désigne une cellule-mémoire du type à « programmation électrique irréversible » ou encore du type « programmable une fois », appartenant à un dispositif de mémoire DM, réalisée par exemple au sein d'un circuit intégré CI.

Cette cellule CEL comporte une zone diélectrique fusible C formée ici d'un condensateur possédant un diélectrique OX encadré par une première électrode EC1 et une deuxième électrode EC2.

La cellule comporte également un circuit d'accès comportant ici un seul transistor d'accès TR qui peut être un transistor bipolaire ou bien un transistor MOS, ou encore un transistor du type à « gradient de champ ». Cela étant le circuit d'accès peut également comporter par exemple deux transistors MOS cascodés.

La première électrode EC1 du condensateur est connectée à une première borne d'alimentation BA par l'intermédiaire d'un circuit auxiliaire CAX comportant ici un transistor auxiliaire TRX par exemple du type PMOS.

La première borne d'alimentation, par exemple un niveau de métallisation du circuit intégré, est destinée à être polarisée avec une tension de polarisation HV qui est égale à une tension de programmation Vprog, par exemple de l'ordre de 7 volts, en mode de programmation.

Dans un tel mode de programmation, le transistor d'accès TR doit être passant, ce qui est par exemple obtenu en fixant sa tension de grille à une valeur égale à 2,5 volts et en fixant sa tension de source à une valeur nulle.

Afin de pouvoir appliquer la tension Vprog sur la première électrode EC1 du condensateur C de la cellule CEL qui doit être programmée, on rend également passant le transistor auxiliaire TRX en appliquant une tension VbP sur sa grille, de telle sorte que la tension grille/source du transistor TRX soit inférieure à sa tension de seuil (par exemple de l'ordre de -0,7 volt).

Par ailleurs, le transistor TRX présente un courant de saturation $I_{sat}$ (TRX) inférieur au courant de saturation $I_{sat}$ (CEL) du transistor d'accès TR de la cellule CEL.

L'homme du métier saura ajuster les différents paramètres des transistors ainsi que les différentes tensions à appliquer de façon à obtenir cette condition entre les courants de saturation qui se traduit par la formule suivante :

$$\mu_n \left(\frac{W}{L}\right)_n \left(V_{gsn} - V_{thn}\right)^2 > \mu_p \left(\frac{W}{L}\right)_p \left(V_{gsp} - V_{thp}\right)^2 \qquad \text{(I)}$$

dans laquelle

- $\mu_n$ désigne la mobilité des électrons du transistor TR (transistor NMOS),
- $\mu_p$ désigne la mobilité des trous dans le transistor TRX,
- $(W/L)_n$ désigne le rapport largeur sur longueur du canal du transistor TR,
- $(W/L)_p$ désigne le rapport largeur sur longueur du canal du transistor TRX,
- $V_{thn}$ désigne la tension de seuil du transistor TR,
- $V_{thp}$ désigne la tension de seuil du transistor TRX,
- $V_{gsn}$ désigne la différence de tension grille/source du transistor TR, et
- $V_{gsp}$ désigne la différence de tension grille/source du transistor TRX.

En raison de la présence du transistor TRX et du fait que le courant de saturation de ce transistor TRX est inférieur au courant de saturation du transistor d'accès TR, on obtient, lors d'une programmation, des évolutions de tensions du type de celles illustrées sur la figure 2.

Sur cette figure 2, la courbe CB1 illustre l'évolution de la tension au drain du transistor TRX, c'est-à-dire ici sur la première électrode EC1 du condensateur C, tandis que la courbe CB2 illustre l'évolution de la tension de drain du transistor TR, c'est-à-dire ici la tension sur la deuxième électrode EC2 du condensateur C, ou encore l'évolution de la tension drain/source Vds du transistor TR puisque la tension de source de ce transistor est égale à zéro.

Plus précisément, à l'instant T0, on applique la tension de programmation Vprog sur la borne d'alimentation BA. Au bout d'une certaine durée, qui expire à l'instant T1, se produit le claquage du diélectrique, c'est-à-dire sa détérioration irréversible par l'apparition de défauts, qui vont conférer au diélectrique une valeur résistive. Ceci marque la programmation effective de la cellule CEL. La cellule et alors considérée comme programmée avec un « 1 » logique par exemple, alors que si le diélectrique n'est pas « claqué », la cellule reste programmée avec un « 0 » logique par exemple.

Lors du claquage du diélectrique OX, il se crée un chemin résistif entre la borne d'alimentation BA et la masse, ce qui se traduit par une chute de la tension sur la première électrode EC1 pour atteindre la valeur HVint.

Par ailleurs, la tension drain/source Vds du transistor TR augmente pour se stabiliser à une valeur Vds0.

La différence entre les valeurs HVint et Vds0 est égale à la différence de tension Vcap aux bornes du condensateur électriquement claqué.

Puisque le courant de saturation du transistor TRX est inférieur au courant de saturation du transistor TR, la valeur Vds0 reste inférieure à la valeur de saturation de cette tension et donc inférieure à la tension nominale. De ce fait, le transistor TR travaille dans une plage nominale, ce qui permet d'assurer une bonne fiabilité.

Par ailleurs, comme on le verra ci après, la détection de la chute de tension au niveau du drain du transistor TRX permet de détecter l'instant de programmation de la cellule CEL.

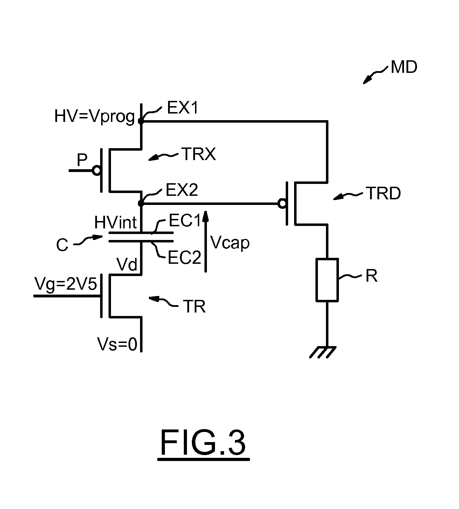

La figure 3 illustre un mode de réalisation de moyens de détection MD permettant de détecter la programmation effective de la cellule-mémoire, c'est-à-dire la dégradation de la zone diélectrique, en détectant plus particulièrement la chute de tension en un endroit situé entre le transistor auxiliaire TRX et la première électrode EC1.

Plus particulièrement, si l'on considère que le transistor TRX comporte une première électrode auxiliaire EX1 destinée à recevoir la tension de programmation Vprog, et une deuxième électrode auxiliaire EX2 (en l'espèce le drain) couplée à la première électrode EC1, les moyens de détection comportent ici un transistor TRD, par exemple un transistor PMOS dont le drain est relié à la première électrode auxiliaire EX1 et donc en fait à la première borne d'alimentation BA. La grille du transistor TRD est reliée à la deuxième électrode auxiliaire EX2 et la source du transistor TRD est reliée à la masse par l'intermédiaire d'une résistance.

Ainsi, lorsqu'on applique une tension de programmation Vprog, par exemple 7 volts, sur la zone diélectrique du condensateur de la cellule au travers du transistor auxiliaire TRX qui est dans son état passant, on retrouve cette tension Vprog sur la grille du transistor TRD tant que la zone diélectrique n'a pas été électriquement claquée.

Par contre, comme illustré sur la figure 2, quand cette zone diélectrique est électriquement claquée, il y a une chute de tension au niveau du drain du transistor TRX, ce qui se traduit par une chute de tension au niveau de la grille du transistor TRD. La tension HVint devient alors égale par exemple à 5 volts. De ce fait, la tension grille/source du transistor TRD est inférieure à la tension de seuil de ce transistor. Le transistor TRD devient passant et il en résulte alors un courant dans la résistance R que l'on peut aisément détecter.

Bien entendu, ce mode de réalisation n'est qu'un exemple, et de nombreuses variantes sont possibles. On pourrait par exemple remplacer le transistor TRD par un comparateur recevant sur son entrée « moins » une tension de référence, et ayant son entrée « plus » reliée à l'électrode EX2 du transistor TRX.

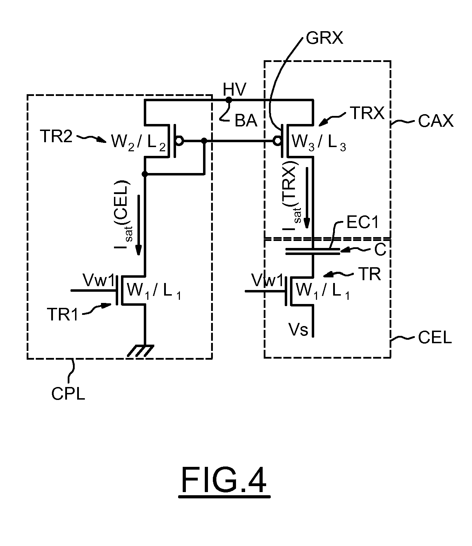

Le mode de réalisation illustré sur la figure 4 permet de façon simple d'obtenir un transistor auxiliaire TRX présentant un courant de saturation inférieur au courant de saturation du transistor d'accès TR de la cellule CEL.

A cet égard, on prévoit de réaliser au sein du circuit intégré un circuit de polarisation CPL électriquement couplé à l'électrode de commande auxiliaire GRX (la grille) du transistor TRX, ce circuit de polarisation CPL comportant un premier transistor TR1 identique au transistor d'accès, c'est-à-dire présentant un rapport W1/L1 identique au rapport W1/L1 du transistor d'accès TR.

Le circuit de polarisation CPL comporte en outre un deuxième transistor TR2, en l'espèce un transistor PMOS, électriquement couplé entre la borne d'alimentation BA et le drain du transistor NMOS TR1 et formant avec le transistor TRX un miroir de courant.

Par ailleurs, le transistor TR2 est agencé de façon à présenter un rapport W2/L2 supérieur au rapport W3/L3 du transistor auxiliaire TRX.

Lors d'une opération de programmation, la tension Vw1 appliquée sur le transistor TR1 rend celui-ci passant, ce qui abaisse la tension appliquée sur la grille du transistor TRX, le rendant passant et permettant la programmation de la cellule CEL lorsque le transistor d'accès TR est lui-même rendu passant par application de la tension Vw1. Il convient toutefois de noter que l'application de la tension Vw1 sur le transistor TR1 peut être effectuée avant l'application de cette tension sur le transistor d'accès TR.

Lors de cette opération, un courant identique circule à travers les transistors TR1 et TR2 (en faisant l'hypothèse qu'il n'y a ni courant de grille ni courant de substrat). Les transistors TR1 et TR2 opérant tous les deux dans la région de saturation, ce courant identique est égal au courant de saturation du transistor TR1 par exemple, c'est-à-dire au courant de saturation $I_{sat}$ (CEL) du transistor TR, puisque les transistors TR1 et TR sont identiques.

Par ailleurs, les transistors TR2 et TR3 du miroir de courant ont la même tension de seuil, la même mobilité et la même tension grille/source. Mais, puisque le rapport W2/L2 est supérieur au rapport W3/L3, il en résulte que le courant de saturation du transistor TR2 est supérieur au courant de saturation $I_{sat}$ (TRX) du transistor auxiliaire TRX. Par conséquent, le courant de saturation du transistor TRX est inférieur au courant de saturation du transistor TR2 et par conséquent du transistor TR1 et par conséquent du transistor TR.

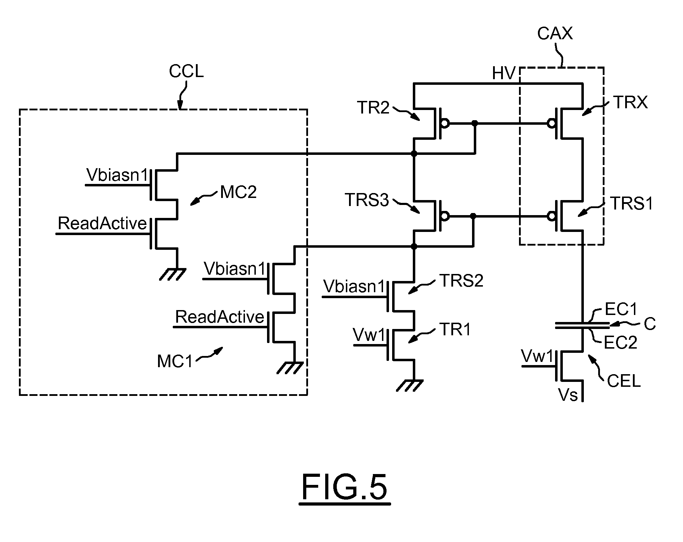

Dans le mode de réalisation illustré sur la figure 5, le circuit auxiliaire CAX comporte un premier transistor supplémentaire TRS1, par exemple un transistor PMOS, électriquement couplé entre le transistor TRX et l'électrode EC1 du condensateur C, et formant avec le transistor TRX un premier montage cascode. Ce transistor TRS1 est associé à un autre transistor TRS3 pour former ensemble un miroir de courant. Par ailleurs, un deuxième transistor supplémentaire TRS2 est électriquement couplé au premier transistor TR1 pour former un deuxième montage cascode.

Ces montages cascodes permettent d'améliorer la fiabilité du transistor TRX et du transistor TR1. Ils permettent également une meilleure précision dans la recopie des courants.

Par ailleurs, on a également représenté sur la figure 5 des moyens de contrôle en lecture CCL comportant deux montages cascodes MC1 et MC2, respectivement couplés aux grilles des transistors TRX et TRS1. Lors de la montée du signal logique « Read Active », les tensions des grilles des transistors TRX et TRS1 sont tirées vers la masse, ce qui permet de rendre passants ces transistors et qui permet la lecture de la cellule CEL sélectionnée en appliquant cette fois-ci une tension de lecture HV beaucoup plus faible, par exemple de l'ordre de 2,5 volts. Vbiasn1 est choisie pour rendre passants les transistors recevant cette tension sur leur grille.

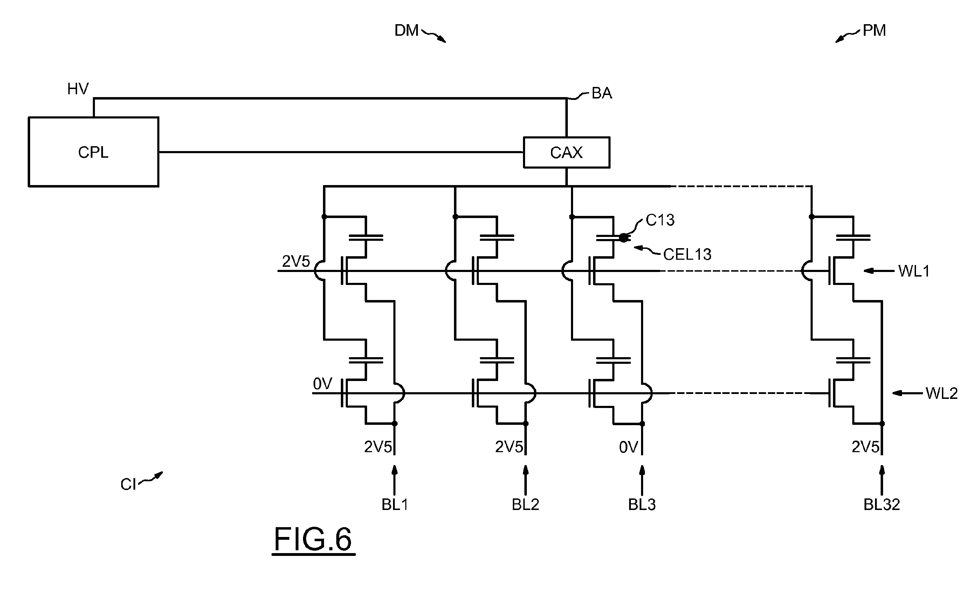

Sur la figure 6, on a représenté un dispositif mémoire DM comportant un plan-mémoire PM composé d'une matrice de cellules-mémoires.

Cette matrice comporte des premiers ensembles de cellules, par exemple des lignes de cellules WLi. Ces lignes forment des lignes de mots de la mémoire. Par ailleurs, le plan-mémoire comporte des deuxièmes ensembles de cellules, par exemple des colonnes de cellules BLi qui forment les lignes de bits de la mémoire.

Dans l'architecture présentée sur la figure 6, un seul circuit auxiliaire CAX et son circuit de polarisation associé sont connectés entre la borne d'alimentation BA et chacune des colonnes du plan-mémoire. Ceci permet alors une programmation bit par bit de la mémoire. A titre d'exemple, sur la figure 6, la cellule CEL13 est programmée avec un « 1 » logique (claquage du diélectrique du condensateur C13).

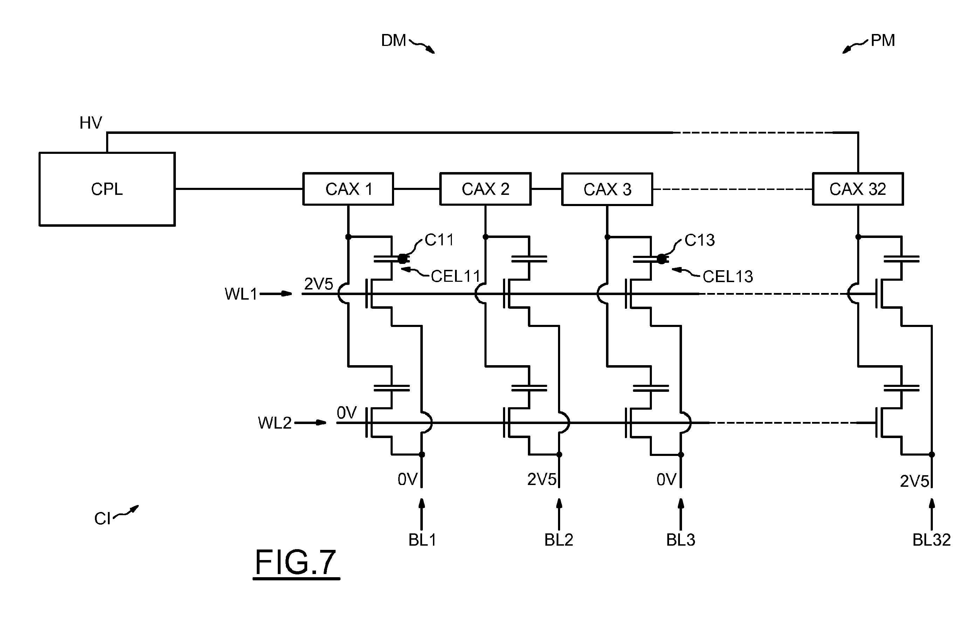

Dans l'exemple d'architecture de la figure 7, un circuit auxiliaire CAXi est associé à chacune des colonnes de la mémoire. Par contre, un seul circuit de polarisation CPL est commun à tous les circuits auxiliaires CAXi.

Ceci permet une programmation simultanée de tous les bits d'une ligne de la mémoire. Dans l'exemple de la figure 7, les cellules CEL11 et CEL13 sont programmées avec un « 1 » logique tandis que les autres cellules de la ligne sont programmées avec des « 0 ».

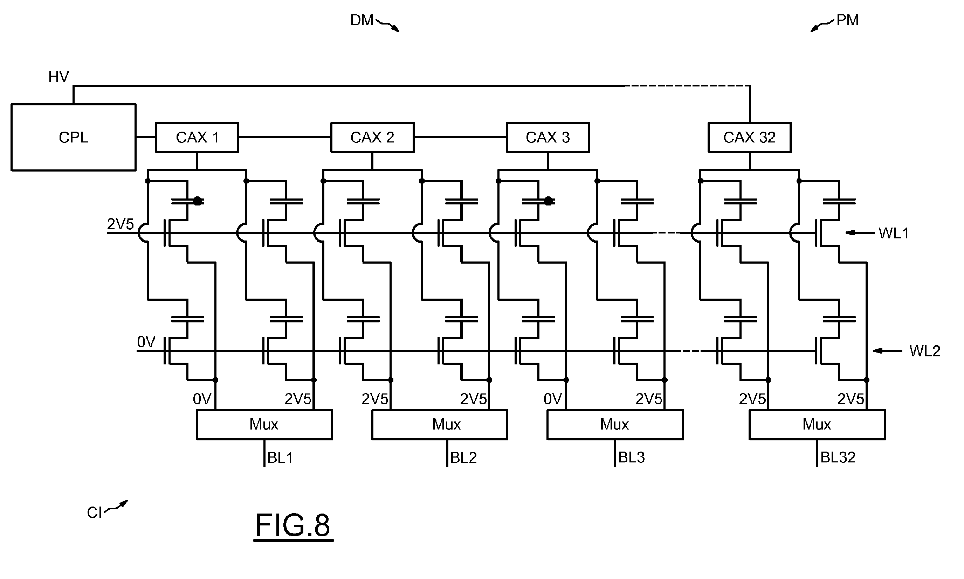

Enfin, bien qu'il soit possible de regrouper les colonnes par groupes de $2^n$ colonnes, avec n supérieur ou égal à 1, les colonnes du plan-mémoire sont, sur la figure 8, regroupées par paires avec, un multiplexeur au pied de chaque paire de colonnes. Et, un circuit auxiliaire CAXi est associé à chaque paire de colonnes. Là encore, un seul circuit de polarisation est associé à tous les circuits auxiliaires CAX1-CAX32. Une telle architecture permet d'optimiser le facteur de forme ainsi que la capacité parasite présentée par la ligne de bits. Le temps de lecture de la mémoire peut être ainsi optimisé.

Les modes de réalisation et de mise en oeuvre qui viennent d'être décrits présentent notamment les avantages suivants :

- fiabilité améliorée pour les transistors d'accès des cellules sélectionnées en programmation,
- détection de la programmation possible,
- facilité de conception des circuits auxiliaires,
- densité surfacique importante des circuits auxiliaires,
- possibilité d'ajuster directement le courant de programmation, et ceci, indépendamment du choix du type de transistor d'accès.

Enfin, une programmation parallèle et un multiplexage des colonnes sont possibles.

## Revendications

1. Circuit intégré comprenant un dispositif de mémoire du type électriquement programmable de façon irréversible comportant au moins une cellule-mémoire (CEL) comportant une zone diélectrique (C) disposée entre une première électrode (EC1) électriquement couplée à une première borne (BA) d'alimentation et une deuxième électrode (EC2) électriquement couplée à un circuit d'accès incluant au moins un transistor d'accès (TR), **caractérisé par le fait que** le dispositif de mémoire (DM) comprend en outre un circuit auxiliaire (CAX) comportant un transistor auxiliaire (TRX) électriquement couplé entre ladite première électrode et ladite première borne d'alimentation, apte à être commandé sur son électrode de commande auxiliaire de façon à être passant lorsque le circuit d'accès (TR) est passant, et agencé de façon à présenter un courant de saturation inférieur au courant de saturation du circuit d'accès.

2. Circuit intégré selon la revendication 1, dans lequel le dispositif de mémoire comprend en outre des moyens de détection (MD) électriquement couplés au transistor auxiliaire et aptes à détecter une dégradation de la zone diélectrique de la cellule-mémoire lors d'une programmation irréversible de ladite cellule-mémoire.

3. Circuit intégré selon la revendication 2, dans lequel le transistor auxiliaire (TRX) comporte une première électrode auxiliaire (EX1) électriquement couplée à ladite première borne d'alimentation et une deuxième électrode auxiliaire (EX2) électriquement couplée à ladite première électrode, et les moyens de détection (MD) sont aptes à détecter une variation de tension en un endroit situé entre ladite deuxième électrode auxiliaire et ladite première électrode.

4. Circuit intégré selon l'une des revendications précédentes, dans lequel le dispositif de mémoire comprend en outre un circuit de polarisation (CPL), électriquement couplé à ladite électrode de commande auxiliaire, et comportant un premier transistor (TR1), identique au transistor d'accès (TR), un deuxième transistor (TR2) électriquement couplé entre le premier transistor et la première borne d'alimentation et formant avec ledit transistor auxiliaire (TRX) un miroir de courant, le rapport W/L de ce deuxième transistor (TR2) étant supérieur au rapport W/L du transistor auxiliaire (TRX), W et L désignant respectivement la largeur et la longueur du canal du transistor.

**5.** Circuit intégré selon la revendication 4, dans lequel le circuit auxiliaire (CAX) comporte en outre un premier transistor supplémentaire (TRS1) électriquement couplé entre le transistor auxiliaire et ladite première électrode et formant avec le transistor auxiliaire un premier montage cascode, et le circuit de polarisation comporte en outre un deuxième transistor supplémentaire (TRS2) électriquement couplé entre le premier transistor et le deuxième transistor et formant avec le premier transistor (TR1) un deuxième montage cascode.

**6.** Circuit intégré selon l'une des revendications précédentes, dans lequel le dispositif de mémoire comporte un plan-mémoire comportant des premiers ensembles de cellules-mémoires s'étendant selon une première direction et des deuxièmes ensembles de cellules-mémoires s'étendant selon une deuxième direction, toutes les premières électrodes des cellules-mémoires étant électriquement couplées à ladite première borne d'alimentation, et le circuit auxiliaire (CAX) est commun à tous les deuxièmes ensembles de cellules-mémoires.

**7.** Circuit intégré selon l'une des revendications 1 à 5, dans lequel le dispositif de mémoire comporte un plan-mémoire comportant des premiers ensembles de cellules-mémoires s'étendant selon une première direction et des deuxièmes ensembles de cellules-mémoires s'étendant selon une deuxième direction, toutes les premières électrodes des cellules-mémoires étant électriquement couplées à ladite première borne d'alimentation, et le dispositif de mémoire comporte un circuit auxiliaire (CAXi) par deuxième ensemble de cellules-mémoires, et un seul circuit de polarisation (CPL) pour tous les circuits auxiliaires.

**8.** Circuit intégré selon l'une des revendications 1 à 5, dans lequel le dispositif de mémoire comporte un plan-mémoire comportant des premiers ensembles de cellules-mémoires s'étendant selon une première direction et des deuxièmes ensembles de cellules-mémoires s'étendant selon une deuxième direction et réparties en groupes de deuxièmes ensembles, toutes les premières électrodes des cellules-mémoires étant électriquement couplées à ladite première borne d'alimentation, et le dispositif de mémoire comporte un circuit auxiliaire (CAXi) par groupe de deuxièmes ensembles de cellules-mémoires, et un seul circuit de polarisation (CPL) pour tous les circuits auxiliaires.

**9.** Procédé de programmation d'un dispositif de mémoire du type électriquement programmable de façon irréversible comportant au moins une cellule-mémoire comportant une zone diélectrique électriquement couplée à un circuit d'accès incluant au moins un transistor d'accès, **caractérisé par le fait qu'**on applique une tension de programmation (Vprog) sur ladite zone diélectrique (OX) au travers d'au moins un transistor auxiliaire (TRX) dans son état passant, le courant de saturation du transistor auxiliaire étant inférieur au courant de saturation traversant le circuit d'accès

**10.** Procédé selon la revendication 9, dans lequel on détecte une dégradation de la zone diélectrique de la cellule-mémoire lors d'une programmation irréversible de ladite cellule-mémoire.

**11.** Procédé selon la revendication 10, dans lequel ladite détection comprend une détection d'une variation de tension en un endroit situé entre le transistor auxiliaire et la zone diélectrique.

DM

BA

HV=Vprog

CAX

VbP ──o| TRX

HVint ── EC1
C ── EC2   Vcap
OX ── Vd
Vg=2V5 ── TR   CEL
Vs=0

## FIG.1

Tension

HV

Vcap=Vprog

CB1

HVint

Vcap

CB2

Vds0

Vds

T0

T1

Temps

claquage
diélectrique

## FIG.2

## FIG.3

$$\underline{FIG.4}$$

## FIG.5

FIG.6

FIG.7

FIG.8

Europäisches
Patentamt

European
Patent Office

Office européen
des brevets

**RAPPORT DE RECHERCHE EUROPEENNE**

Numéro de la demande

EP 09 15 7269

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | WO 2007/040847 A (CYPRESS SEMICONDUCTOR CORP [US]; JENNE FREDRICK B [US]) 12 avril 2007 (2007-04-12) * page 15, ligne 17 - page 17, ligne 13; figure 13 * * page 18, ligne 6 - ligne 17; figure 15 * ----- | 1-11 | INV. G11C17/16 G11C17/18 |
| Y | JP 59 087697 A (TOKYO SHIBAURA ELECTRIC CO) 21 mai 1984 (1984-05-21) * abrégé; figure 3 * ----- | 1-11 | |
| A | EP 1 583 239 A (KILOPASS TECHNOLOGIES INC [US] KILOPASS TECHNOLOGY INC [US]) 5 octobre 2005 (2005-10-05) * alinéa [0046] - alinéa [0047]; figure 8 * ----- | 2,3,10, 11 | |
| A | EP 1 351 255 A (HEWLETT PACKARD CO [US]) 8 octobre 2003 (2003-10-08) * alinéa [0027] - alinéa [0028]; figures 10,11 * ----- | 5 | |
| A | WO 2006/017416 A (ANALOG DEVICES INC [US]; BRENNAN OLIVER [IE]; DOYLE DENIS [IE]) 16 février 2006 (2006-02-16) * page 8, alinéa 2 - page 12, alinéa 2; figures 1-4 * ----- | 1-11 | DOMAINES TECHNIQUES RECHERCHES (IPC)<br><br>G11C |

| Le présent rapport a été établi pour toutes les revendications | | |
|---|---|---|
| Lieu de la recherche<br>La Haye | Date d'achèvement de la recherche<br>2 juin 2009 | Examinateur<br>Colling, Pierre |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 09 15 7269

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

02-06-2009

| Document brevet cité au rapport de recherche | | Date de publication | Membre(s) de la famille de brevet(s) | | Date de publication |
|---|---|---|---|---|---|
| WO 2007040847 | A | 12-04-2007 | AUCUN | | |
| JP 59087697 | A | 21-05-1984 | AUCUN | | |
| EP 1583239 | A | 05-10-2005 | JP | 2005269616 A | 29-09-2005 |
| EP 1351255 | A | 08-10-2003 | JP | 3749234 B2 | 22-02-2006 |
| | | | JP | 2003308699 A | 31-10-2003 |
| | | | TW | 258858 B | 21-07-2006 |
| | | | US | 2003186468 A1 | 02-10-2003 |
| | | | US | 2004141351 A1 | 22-07-2004 |
| | | | US | 2004145008 A1 | 29-07-2004 |
| WO 2006017416 | A | 16-02-2006 | CN | 1993768 A | 04-07-2007 |
| | | | EP | 1774531 A2 | 18-04-2007 |
| | | | JP | 2008509506 T | 27-03-2008 |
| | | | TW | 283410 B | 01-07-2007 |
| | | | US | 2006028894 A1 | 09-02-2006 |

EPO FORM P0460

Pour tout renseignement concernant cette annexe : voir Journal Officiel de l'Office européen des brevets, No.12/82